# EUROPEAN PATENT SPECIFICATION

(11) **EP 3 400 266 B1**
(45) Date of publication and mention of the grant of the patent: **24.08.2022**
(21) Application number: 17736379.3
(22) Date of filing: 06.01.2017
(51) Int. Cl.: C09K 3/14, C09G 1/02, H01L 21/3105

(54) **METHOD OF POLISHING A LOW-K SUBSTRATE**
POLIERVERFAHREN FÜR EIN SUBSTRAT MIT NIEDRIGER ELEKTRIZITÄTSKONSTANTE
PROCÉDÉ DE POLISSAGE D'UN SUBSTRAT À FAIBLE K

(30) Priority: 06.01.2016 US 201662275392 P
(43) Date of publication of application: 14.11.2018
(73) Proprietor: CMC Materials, Inc., Aurora, IL 60504 (US)
(72) Inventor: PALLIKKARA KUTTIATOOR, Sudeep, Aurora Illinois 60504 (US); JIA, Renhe, Aurora Illinois 60504 (US); CHEN, Kuen-Min, Aurora Illinois 60504 (US); KRAFT, Steven, Aurora Illinois 60504 (US); CARTER, Phillip W., Aurora Illinois 60504 (US)
(74) Representative: Barker Brettell LLP
(86) International application number: PCT/US2017/012419
(87) International publication number: WO 2017/120396

(56) References cited:
- EP-A1- 1 493 789
- EP-A1- 1 566 420
- US-A1- 2013 273 739
- US-A1- 2015 376 463
- US-B1- 6 569 349
- US-B1- 9 127 187
- US-B2- 7 456 107
- US-B2- 8 314 028
- US-B2- 9 165 489

## Description

### BACKGROUND OF THE INVENTION

Compositions and methods for planarizing or polishing the surface of a substrate are well known in the art. Polishing compositions (also known as polishing slurries) typically contain an abrasive material in a liquid carrier and are applied to a surface by contacting the surface with a polishing pad saturated with the polishing composition. Typical abrasive materials include silicon dioxide, cerium oxide, aluminum oxide, zirconium oxide, and tin oxide. Polishing compositions are typically used in conjunction with polishing pads (e.g., a polishing cloth or disk). Instead of, or in addition to, being suspended in the polishing composition, the abrasive material may be incorporated into the polishing pad.

As a method for isolating elements of a semiconductor device, a great deal of attention is being directed toward a shallow trench isolation (STI) process where a silicon nitride layer is formed on a silicon substrate, shallow trenches are formed via etching or photolithography, and a dielectric layer (e.g., an oxide) is deposited to fill the trenches. Due to variation in the depth of trenches, or lines, formed in this manner, it is typically necessary to deposit an excess of dielectric material on top of the substrate to ensure complete filling of all trenches. The excess dielectric material is then typically removed by a chemical-mechanical planarization process to expose the silicon nitride layer. When the silicon nitride layer is exposed, the largest area of the substrate exposed to the chemical-mechanical polishing composition comprises silicon nitride, which must then be polished to achieve a highly planar and uniform surface.

Generally, past practice has been to emphasize selectivity for oxide polishing in preference to silicon nitride polishing. Thus, the silicon nitride layer has served as a stopping layer during the chemical-mechanical planarization process, as the overall polishing rate decreased upon exposure of the silicon nitride layer.

Recently, selectivity for oxide polishing in preference to polysilicon polishing has also been emphasized. For example, the addition of a series of BRIJ^{™} and polyethylene oxide surfactants, as well as PLURONIC^{™} L-64, an ethylene oxide-propylene oxideethylene oxide triblock copolymer with an HLB of 15, is purported to increase the polishing selectivity of oxide to polysilicon (see Lee et al., "Effects of Nonionic Surfactants on Oxide-to-Polysilicon Selectivity during Chemical Mechanical Polishing," J. Electrochem. Soc., 149(8): G477-G481 (2002)). Also, U.S. Patent 6,626,968 discloses that polishing selectivity of silicon oxide to polysilicon can be improved through the use of a polymer additive having hydrophilic and hydrophobic functional groups selected from polyvinylmethylether, polyethylene glycol, polyoxyethylene 23 lauryl ether, polypropanoic acid, polyacrylic acid, and polyether glycol *bis*(ether). EP 1566420 A1 discloses a chemical mechanical polishing aqueous dispersion comprising abrasives (A) containing ceria, an anionic water-soluble polymer (B) and a cationic surfactant (C), wherein the amount of the anionic water-soluble polymer (B) is in the range of 60 to 600 parts by mass based on 100 parts by mass of the abrasives (A) containing ceria, and the amount of the cationic surfactant (C) is in the range of 0.1 to 100 ppm based on the whole amount of the chemical mechanical polishing aqueous dispersion. US 2015/376463 A1 discloses a chemical-mechanical polishing composition including colloidal silica abrasive particles having a chemical compound incorporated therein. The chemical compound may include a nitrogen-containing compound such as an aminosilane or a phosphorus-containing compound. Methods for employing such compositions include applying the composition to a semiconductor substrate to remove at least a portion of at least one of a copper, a copper barrier, and a dielectric layer.

The STI substrate is typically polished using a conventional polishing medium and an abrasive-containing polishing composition. However, polishing STI substrates with conventional polishing media and abrasive-containing polishing compositions has been observed to result in overpolishing of the substrate surface or the formation of recesses in the STI features and other topographical defects such as microscratches on the substrate surface. This phenomenon of overpolishing and forming recesses in the STI features is referred to as dishing. Dishing is undesirable because dishing of substrate features may detrimentally affect device fabrication by causing failure of isolation of transistors and transistor components from one another, thereby resulting in short-circuits. Additionally, overpolishing of the substrate may also result in oxide loss and exposure of the underlying oxide to damage from polishing or chemical activity, which detrimentally affects device quality and performance.

Thus, there remains a need in the art for polishing compositions and methods that can provide desirable selectivity of silicon oxide, silicon nitride, and polysilicon and that have suitable removal rates, low defectivity, and suitable dishing performance.

### BRIEF SUMMARY OF THE INVENTION

The invention provides a method of chemically-mechanically polishing a substrate. The method comprises, consists of, or consists essentially of (a) contacting a substrate containing a low-k dielectric composition, wherein the low-k dielectric composition has a dielectric constant between 2 and 3 and the low-k dielectric composition includes less than about 50% by weight of carbon, with a polishing pad and a chemical-mechanical polishing composition comprising water and abrasive particles having a positive surface charge and a zeta potential of at least about +10 mV, wherein the abrasive particles include wet process ceria and wherein the polishing composition has a pH of from about 3 to about 6; (b) moving the polishing pad and the chemical-mechanical polishing composition relative to the substrate; and (c) abrading at least a portion of the substrate to polish the substrate. In some embodiments, the low-k dielectric composition is carbon-doped silicon oxide.

### BRIEF DESCRIPTION OF THE SEVERAL VIEWS OF THE DRAWING(S)

FIG. 1 is a graph of step height in Angstroms (Y-Axis) versus total polish time in seconds (X-axis) for the polishing composition of Example 2 herein.
FIG. 2 is a graph of silicon nitride removal (Y-axis) versus total polishing time in seconds (X-axis) for the polishing composition of Example 2 herein.
FIG. 3 is a bar graph illustrating removal rates of TEOS, SiN, and carbon-doped silicon oxide film containing 50% carbon (Y-axis) of the polishing compositions (X-axis) of Example 3 herein.

### DETAILED DESCRIPTION OF THE INVENTION

The invention provides a method of chemically-mechanically polishing a substrate. The method comprises, consists of, or consists essentially of (a) contacting a substrate containing a low-k dielectric composition, wherein the low-k dielectric composition has a dielectric constant between 2 and 3 and the low-k dielectric composition includes less than about 50% by weight of carbon, with a polishing pad and a chemical-mechanical polishing composition comprising water and abrasive particles having a positive surface charge and a zeta potential of at least about +10 mV, wherein the abrasive particles include wet process ceria and wherein the polishing composition has a pH of from about 3 to about 6; (b) moving the polishing pad and the chemical-mechanical polishing composition relative to the substrate; and (c) abrading at least a portion of the substrate to polish the substrate.

The inventive method has particular application with substrates containing low-k dielectric materials. For example, in one aspect, the invention surprisingly and unexpectedly can achieve effective removal rates with carbon-doped silicon oxide materials, particularly with those containing less than about 50% by weight oxygen, less than about 40% by weight oxygen, less than about 30% by weight oxygen, less than about 20% by weight oxygen, or less than about 10% by weight oxygen). The amount of silicon in the carbon-doped silicon oxide material can be any suitable amount, e.g., from about 1% by weight to about 95% weight, such as from about 10% by weight to about 50% by weight, or from about 20% by weight to about 40% by weight. The amount of oxygen in the carbon-doped silicon oxide material also can be any suitable amount, e.g., from about 1% by weight to about 95% weight, such as from about 10% by weight to about 50% by weight, or from about 20% by weight to about 40% by weight. Such carbon-doped silicon oxide materials have been heretofore difficult to polish effectively because they are hydrophobic and relatively soft materials. This has posed a challenge in using polishing compositions which are aqueous and thus hydrophilic, while containing abrasive particles.

The inventive method surprisingly and unexpectedly achieves silicon oxide removal by polishing with a polishing composition exhibiting a moderately acidic pH of from about 3 to about 6 and using abrasive particles with positive surface charge and a zeta potential of at least about +10 mV, wherein the abrasive particles include wet process ceria. While not wishing to be bound by any particular theory, the inventors have found that a polishing composition with a pH within the range of about from about 3 to about 6 is desirable in accordance with preferred embodiments because of favorable electrostatic attraction enhancing film removal.

In some embodiments, the pH of the polishing composition is from about 3 to about 5.6, e.g., from about 3 to about 5, from about 3 to about 4.5, from about 3 to about 4, from about 3 to about 3.5, from about 3.5 to about 6, from about 3.5 to about 5.6, from about 3.5 to about 5, from about 3.5 to about 4.5, from about 3.5 to about 4.5, from about 3.5 to about 4, from about 4 to about 6, from about 4 to about 5.6, from about 4 to about 5, from about 4 to about 4.5, from about 4.5 to about 6, from about 4.5 to about 5.6, from about 4.5 to about 5, or from about 5 to about 6. In some embodiments, the pH of the composition is from about 5 to about 5.6.

The low-k material contains a material having a dielectric constant between 2 and 3 (e.g., between about 2.5 and about 3).

The inventive method can be used in polishing a wide variety of semiconductor wafers used in fabrication of integrated circuits and other microdevices. In one aspect, the inventive method can be used with a shallow trench isolation (STI) process where a silicon nitride layer is formed on a silicon substrate. Shallow trenches are formed, e.g., via etching or photolithography on the substrate. The carbon-doped silicon oxide material as described above can be used as the insulator material to fill the trenches. Such carbon-doped silicon oxide material is desirable because it has good filling ability of the trenches with low risk of leakage or shorting of the current. This is particularly beneficial in advanced node applications where there are smaller features densely packed on the devices.

Thus, in some embodiments, the inventive method is particularly suited for use with advanced node applications (e.g., technology nodes of 28 nm or less, 22 nm or less, 18 nm or less, 16 nm or less, 14 nm or less, 10 nm or less, 8 nm or less, etc.). It will be understood that, as node technology becomes more advanced, the absence of defectivity in planarization technology becomes more important because the effects of each scratch have more of an impact as the relative size of features on the wafer gets smaller. However, the wafers can be of conventional node configuration in some embodiments, e.g., technology nodes of 65 nm or less, 45 nm or less, 32 nm or less, etc.

In some embodiments, the inventive method is desirably able to selectively polish and remove the silicon oxide while avoiding or reducing removal of the underlying silicon nitride liner layer, which is sometimes referred to as "stop on nitride" in the art. In some embodiments, the inventive method avoids or reduces excessive removal of the silicon oxide in the trenches, known as "dishing," as discussed in more detail below.

The polishing composition comprises an abrasive. The abrasive desirably exhibits a positive surface charge within the desired pH range of 3 to 6 (or desired pH sub-range set forth herein). Positively charged particles are desirable because they enhance the electrostatic attraction toward a negative low-k material, e.g., carbon-containing silicon oxide film, during polishing. The abrasive particles have a zeta potential of at least about +10 mV. In some embodiments, the abrasive particles have a zeta potential of from about +10 mV to about +40 mV, e.g., from about +10 mV to about +30 mV, from about +10 mV to about +20 mV, or from about +20 mV to about +40 mV.

The abrasive particles comprise, consist, or consist essentially of wet-process ceria particles. As known to one of ordinary skill in the art, ceria is an oxide of the rare earth metal cerium, and is also known as ceric oxide, cerium oxide (e.g., cerium(IV) oxide), or cerium dioxide. Cerium(IV) oxide (CeO₂) can be formed by calcining cerium oxalate or cerium hydroxide. Cerium also forms cerium(III) oxides such as, for example, Ce₂O₃. The ceria abrasive can be any one or more of these or other oxides of ceria.

As used herein, "wet-process" ceria refers to a ceria prepared by a precipitation, condensation-polymerization, or similar process (as opposed to, for example, fumed or pyrogenic ceria). A polishing composition of the invention comprising a wet-process ceria abrasive has been typically found to exhibit lower defects when used to polish substrates according to a method of the invention. Without wishing to be bound to a particular theory, it is believed that wet-process ceria comprises spherical ceria particles and/or smaller aggregate ceria particles, thereby resulting in lower substrate defectivity when used in the inventive method. An illustrative wet-process ceria is HC-60^{™} ceria commercially available from Rhodia S.A. (La Defense, France).

The ceria particles can have any suitable average size (i.e., average particle diameter). If the average ceria particle size is too small, the polishing composition may not exhibit sufficient removal rate. In contrast, if the average ceria particle size is too large, the polishing composition may exhibit undesirable polishing performance such as, for example, poor substrate defectivity. Accordingly, the ceria particles can have an average particle size of about 10 nm or more, for example, about 15 nm or more, about 20 nm or more, about 25 nm or more, about 30 nm or more, about 35 nm or more, about 40 nm or more, about 45 nm or more, or about 50 nm or more. Alternatively, or in addition, the ceria can have an average particle size of about 1,000 nm or less, for example, about 750 nm or less, about 500 nm or less, about 250 nm or less, about 150 nm or less, about 100 nm or less, about 75 nm or less, or about 50 nm or less. Thus, the ceria can have an average particle size bounded by any two of the aforementioned endpoints. For example, the ceria can have an average particle size of about 10 nm to about 1,000 nm, about 10 nm to about 750 nm, about 15 nm to about 500 nm, about 20 nm to about 250 nm, about 20 nm to about 150 nm, about 25 nm to about 150 nm, about 25 nm to about 100 nm, or about 50 nm to about 150 nm, or about 50 nm to about 100 nm. For non-spherical ceria particles, the size of the particle is the diameter of the smallest sphere that encompasses the particle. The particle size of the ceria can be measured using any suitable technique, for example, using laser diffraction techniques. Suitable particle size measurement instruments are available from e.g., Malvern Instruments (Malvern, UK).

The ceria particles preferably are colloidally stable in the inventive polishing composition. The term colloid refers to the suspension of ceria particles in the liquid carrier (e.g., water). Colloidal stability refers to the maintenance of that suspension through time. In the context of this invention, an abrasive is considered colloidally stable if, when the abrasive is placed into a 100 mL graduated cylinder and allowed to stand unagitated for a time of 2 hours, the difference between the concentration of particles in the bottom 50 mL of the graduated cylinder ([B] in terms of g/mL) and the concentration of particles in the top 50 mL of the graduated cylinder ([T] in terms of g/mL) divided by the initial concentration of particles in the abrasive composition ([C] in terms of g/mL) is less than or equal to 0.5 (i.e., {[B] - [T]}/[C] ≤ 0.5). More preferably, the value of [B]-[T]/[C] is less than or equal to 0.3, and most preferably is less than or equal to 0.1.

The abrasive is present in any suitable amount. If the polishing composition of the invention comprises too little abrasive, the composition may not exhibit sufficient removal rate. In contrast, if the polishing composition comprises too much abrasive then the polishing composition may exhibit undesirable polishing performance and/or may not be cost effective and/or may lack stability. The polishing composition can comprise about 2 wt.% or less of ceria, for example, about 1.9 wt.% or less, about 1.8 wt.% or less, about 1.7 wt.% or less, about 1.6 wt.% or less, about 1.5 wt.% or less, about 1.4 wt.% or less, about 1.3 wt.% or less, about 1.2 wt.% or less, about 1 wt. % or less, about 0.9 wt.% or less, about 0.8 wt.% or less, about 0.7 wt.% or less, about 0.6 wt.% or less of ceria, or about 0.5 wt.% or less of abrasive. Alternatively, or in addition, the polishing composition can comprise about 0.05 wt.% or more, for example, about 0.1 wt.% or more about 0.2 wt.% or more, about 0.3 wt.% or more, about 0.4 wt.% or more, about 0.5 wt.% or more, or about 1 wt.% or more of abrasive. Thus, the polishing composition can comprise abrasive in an amount bounded by any two of the aforementioned endpoints, as appropriate.

For example, in some embodiments, the abrasive can be present in an amount of from about 0.05 wt.% to about 2.0 wt.% of the polishing composition, e.g., about 0.05 wt.% to about 1.8 wt.%, about 0.05 wt.% to about 1.6 wt.%, about 0.05 wt.% to about 1.4 wt.%, about 0.05 wt.% to about 1.2 wt.%, about 0.05 wt.% to about 1 wt.%, about 0.05 wt.% to about 0.8 wt.%, about 0.05 wt.% to about 0.5 wt.%, about 0.05 wt.% to about 0.2 wt.%, about 0.1 wt.% to about 2 wt.%, about 0.1 wt.% to about 1.6 wt.%, about 0.1 wt.% to about 1.2 wt.%, about 0.1 wt.% to about 0.8 wt.%, about 0.3 wt.% to about 2 wt.%, about 0.3 wt.% to about 1.8 wt.%, about 0.3 wt.% to about 1.4 wt.%, about 0.3 wt.% to about 1 wt.%, about 0.5 wt.% to about 2 wt.%, about 0.5 wt.% to about 1.5 wt.%, about 0.5 wt.% to about 1 wt.%, about 1 wt.% to about 2 wt.%, or about 1 wt.% to about 1.5 wt.%.

In some embodiments, the polishing composition optionally further comprises an ionic polymer of formula (I): 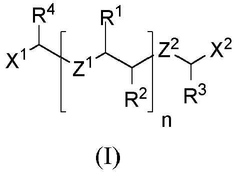 wherein X¹ and X² are independently selected from hydrogen, -OH, and -COOH and wherein at least one of X¹ and X² is -COOH, Z¹ and Z² are independently O or S, R¹, R², R³, and R⁴ are independently selected from hydrogen, C₁-C₆ alkyl, and C₇-C₁₀ aryl, and n is an integer of 3 to about 500.

In certain embodiments, the ionic polymer is of formula I wherein X¹ and X² are both -COOH. In certain embodiments, the ionic polymer is of formula I wherein Z¹ and Z² are both O, and R¹, R², R³, and R⁴ are hydrogen. In certain preferred embodiments, the ionic polymer is of formula I wherein X¹ and X² are both -COOH, Z¹ and Z² are both O, and R¹, R², R³, and R⁴ are hydrogen. The ionic polymer is a polyethylene glycol diacid in some embodiments.

The ionic polymer can have any suitable molecular weight. The ionic polymer can have an average molecular weight of about 250 g/mol or more, for example, about 300 g/mol or more, about 400 g/mol or more, about 500 g/mol or more, about 600 g/mol or more, about 750 g/mol or more, about 1,000 g/mol or more, about 1,500 g/mol or more, about 2,000 g/mol or more, about 2,500 g/mol or more, about 3,000 g/mol or more, about 3,500 g/mol or more, about 4,000 g/mol or more, about 4,500 g/mol or more, about 5,000 g/mol or more, about 5,500 g/mol or more, about 6,000 g/mol or more, about 6,500 g/mol or more, about 7,000 g/mol or more, or about 7,500 g/mol or more. Alternatively, or in addition, the ionic polymer can have an average molecular weight of about 15,000 g/mol or less, for example, about 14,000 g/mol or less, about 13,000 g/mol or less, about 12,000 g/mol or less, about 11,000 g/mol or less, about 10,000 g/mol or less, about 9,000 g/mol or less, about 8,000 g/mol or less, about 7,500 g/mol or less, about 7,000 g/mol or less, about 6,500 g/mol or less, about 6,000 g/mol or less, about 5,500 g/mol or less, about 5,000 g/mol or less, about 4,500 g/mol or less, about 4,000 g/mol or less, about 3,500 g/mol or less, about 3,000 g/mol or less, about 2,500 g/mol or less, or about 2,000 g/mol or less. Thus, the ionic polymer can have an average molecular weight bounded by any two of the aforementioned endpoints.

For example, the ionic polymer can have an average molecular weight of about 250 g/mol to about 15,000 g/mol, about 250 g/mol to about 14,000 g/mol, about 250 g/mol to about 13,000 g/mol, about 250 g/mol to about 12,000 g/mol, about 250 g/mol to about 11,000 g/mol, about 250 g/mol to about 10,000 g/mol, about 400 g/mol to about 10,000 g/mol, about 400 g/mol to about 8,000 g/mol, about 400 g/mol to about 6,000 g/mol, about 400 g/mol to about 4,000 g/mol, about 400 g/mol to about 2,000 g/mol, and the like. In some embodiments, the ionic polymer has a molecular weight of about 500 g/mol to about 10,000 g/mol, and n is an integer with a value of about 8 or greater (e.g., about 8 to about 500).

The polishing composition comprises any suitable amount of ionic polymer at the point-of-use. The polishing composition can comprise about 0.001 wt.% or more, for example, about 0.005 wt.% or more, about 0.01 wt.% or more, about 0.025 wt.% or more, about 0.05 wt.% or more, about 0.075 wt.% or more, or about 0.1 wt.% or more, of the ionic polymer. Alternatively, or in addition, the polishing composition can comprise about 1 wt.% or less, for example, about 0.9 wt.% or less, about 0.8 wt.% or less, about 0.7 wt.% or less, about 0.6 wt.% or less, about 0.5 wt.% or less, about 0.4 wt.% or less, or about 0.3 wt.% or less, of the ionic polymer. Thus, the polishing composition can comprise the ionic polymer in an amount bounded by any two of the aforementioned endpoints. For example, the polishing composition can comprise about 0.001 wt.% to about 1 wt.%, about 0.01 wt.% to about 0.9 wt.%, about 0.025 wt.% to about 0.8 wt.%, about 0.05 wt.% to about 0.7 wt.%, about 0.01 wt.% to about 0.5 wt.%, or about 0.1 wt.% to about 0.5 wt.% of the ionic polymer, and the like.

In some embodiments, the chemical-mechanical polishing composition optionally comprises one or more polyvinyl alcohols. The polyvinyl alcohol can be any suitable polyvinyl alcohol and can be a linear or branched polyvinyl alcohol. Non-limiting examples of suitable branched polyvinyl alcohols are the Nichigo G-polymers, such as the OKS-1009 and OKS-1083 products, available from Nippon Gohsei, Japan.

The polyvinyl alcohol can have any suitable degree of hydrolysis. The degree of hydrolysis refers to the amount of free hydroxyl groups present on the polyvinyl alcohol as compared with the sum of free hydroxyl groups and acetylated hydroxyl groups. Preferably, the polyvinyl alcohol has a degree of hydrolysis of about 90% or more, e.g., about 92% or more, about 94% or more, about 96% or more, about 98% or more, or about 99% or more.

The polyvinyl alcohol can have any suitable molecular weight. The polyvinyl alcohol can have an average molecular weight of about 250 g/mol or more, for example, about 300 g/mol or more, about 400 g/mol or more, about 500 g/mol or more, about 600 g/mol or more, about 750 g/mol or more, about 1,000 g/mol or more, about 2,000 g/mol or more, about 3,000 g/mol or more, about 4,000 g/mol or more, about 5,000 g/mol or more, about 7,500 g/mol or more, about 10,000 g/mol or more, about 15,000 g/mol or more, about 20,000 g/mol or more, about 25,000 g/mol or more, about 30,000 g/mol or more, about 50,000 g/mol or more, or about 75,000 g/mol or more. Alternatively, or in addition, the polyvinyl alcohol can have an average molecular weight of about 250,000 g/mol or less, for example, about 200,000 g/mol or less, about 180,000 g/mol or less, about 150,000 g/mol or less, about 100,000 g/mol or less, about 90,000 g/mol or less, about 85,000 g/mol or less, about 80,000 g/mol or less, about 75,000 g/mol or less, about 50,000 g/mol or less, about 45,000 g/mol or less, about 40,000 g/mol or less, about 35,000 g/mol or less, about 30,000 g/mol or less, about 25,000 g/mol or less, about 20,000 g/mol or less, about 15,000 g/mol or less, about 12,500 g/mol or less, or about 10,000 g/mol or less. Thus, the polyvinyl alcohol can have an average molecular weight bounded by any two of the aforementioned endpoints. For example, the polyvinyl alcohol can have an average molecular weight of about 250 g/mol to about 250,000 g/mol, 250 g/mol to about 200,000 g/mol, 250 g/mol to about 180,000 g/mol, 250 g/mol to about 150,000 g/mol, 250 g/mol to about 100,000 g/mol, about 250 g/mol to about 75,000 g/mol, about 250 g/mol to about 50,000 g/mol, about 250 g/mol to about 25,000 g/mol, about 250 g/mol to about 10,000 g/mol, about 10,000 g/mol to about 100,000 g/mol, about 10,000 g/mol to about 75,000 g/mol, about 10,000 g/mol to about 50,000 g/mol, about 10,000 g/mol to about 40,000 g/mol, about 50,000 g/mol to about 100,000 g/mol, about 75,000 g/mol to about 100,000 g/mol, about 25,000 g/mol to about 200,000 g/mol, or about 50,000 g/mol to about 180,000 g/mol, and the like.

The polishing composition comprises any suitable amount of polyvinyl alcohol at the point-of-use. The polishing composition can comprise about 0.001 wt.% or more, for example, about 0.005 wt.% or more, about 0.01 wt.% or more, about 0.025 wt.% or more, about 0.05 wt.% or more, about 0.075 wt.% or more, or about 0.1 wt.% or more, of the polyvinyl alcohol. Alternatively, or in addition, the polishing composition can comprise about 1 wt.% or less, for example, about 0.9 wt.% or less, about 0.8 wt.% or less, about 0.7 wt.% or less, about 0.6 wt.% or less, about 0.5 wt.% or less, about 0.4 wt.% or less, or about 0.3 wt.% or less, of the polyvinyl alcohol. Thus, the polishing composition can comprise the polyvinyl alcohol in an amount bounded by any two of the aforementioned endpoints. For example, the polishing composition can comprise about 0.001 wt.% to about 1 wt.%, about 0.01 wt.% to about 0.9 wt.%, about 0.025 wt.% to about 0.8 wt.%, about 0.05 wt.% to about 0.7 wt.%, or about 0.1 wt.% to about 0.5 wt.% of the polyvinyl alcohol, and the like.

In some embodiments, the chemical-mechanical polishing composition optionally comprises a polyhydroxy aromatic compound. The polyhydroxy aromatic compound can be any suitable polyhydroxy aromatic compound. The term polyhydroxy aromatic compound refers to an aryl compound or heteroaryl compound having two or more hydroxyl groups bonded to the aryl or heteroaryl ring. Non-limiting examples of suitable polyhydroxy aromatic compounds include 1,2-dihydroxybenzene, 1,3-dihydroxybenzene, 1,4-dihydroxybenzene, 1,3,5-trihydroxybenzene, 1,2,4-trihydroxybenzene, 2,6-dihydroxypyridine, 2,3-dihydroxypyridine, and 2,4-dihydroxypyridine. In preferred embodiments, the polyhydroxy aromatic compound is selected from 1,3-dihydroxybenzene and 1,3,5-trihydroxybenzene.

The polishing composition comprises any suitable amount of polyhydroxy aromatic compound at the point-of-use. The polishing composition can comprise about 0.001 wt.% or more, for example, about 0.005 wt.% or more, about 0.01 wt.% or more, about 0.025 wt.% or more, about 0.05 wt.% or more, about 0.075 wt.% or more, or about 0.1 wt.% or more, of the polyhydroxy aromatic compound. Alternatively, or in addition, the polishing composition can comprise about 1 wt.% or less, for example, about 0.9 wt.% or less, about 0.8 wt.% or less, about 0.7 wt.% or less, about 0.6 wt.% or less, about 0.5 wt.% or less, about 0.4 wt.% or less, or about 0.3 wt.% or less, of the polyhydroxy aromatic compound. Thus, the polishing composition can comprise the polyhydroxy aromatic compound in an amount bounded by any two of the aforementioned endpoints. For example, the polishing composition can comprise about 0.001 wt.% to about 1 wt.%, about 0.01 wt.% to about 0.9 wt.%, about 0.025 wt.% to about 0.8 wt.%, about 0.05 wt.% to about 0.7 wt.%, or about 0.1 wt.% to about 0.5 wt.% of the polyhydroxy aromatic compound, and the like.

The chemical-mechanical polishing composition optionally further comprises one or more additives. Illustrative additives include conditioners, acids (e.g., sulfonic acids), complexing agents (e.g., anionic polymeric complexing agents), chelating agents, biocides, scale inhibitors, dispersants, etc.

The biocide, when present, can be any suitable biocide and can be present in the polishing composition in any suitable amount. A suitable biocide is an isothiazolinone biocide. The amount of biocide used in the polishing composition typically is about 1 to about 50 ppm, preferably about 10 to about 20 ppm.

It will be understood that any of the components of the polishing composition that are acids, bases, or salts (e.g., organic carboxylic acid, base, and/or alkali metal carbonate, etc.), when dissolved in the water of the polishing composition, can exist in dissociated form as cations and anions. The amounts of such compounds present in the polishing composition as recited herein will be understood to refer to the weight of the undissociated compound used in the preparation of the polishing composition.

The polishing composition can be produced by any suitable technique, many of which are known to those skilled in the art. The polishing composition can be prepared in a batch or continuous process. Generally, the polishing composition is prepared by combining the components of the polishing composition. The term "component" as used herein includes individual ingredients (e.g., wet process ceria abrasive, ionic polymer, polyhydroxy aromatic compound, polyvinyl alcohol, optional pH adjustor, and/or any optional additive) as well as any combination of ingredients (e.g., wet process ceria abrasive, ionic polymer, polyhydroxy aromatic compound, polyvinyl alcohol, etc.).

For example, the polishing composition can be prepared by (i) providing all or a portion of the liquid carrier, (ii) dispersing the abrasive (including wet process ceria), ionic polymer, polyhydroxy aromatic compound, polyvinyl alcohol, optional pH adjustor, and/or any optional additive, using any suitable means for preparing such a dispersion, (iii) adjusting the pH of the dispersion as appropriate, and (iv) optionally adding suitable amounts of any other optional components and/or additives to the mixture.

Alternatively, the polishing composition can be prepared by (i) providing one or more components (e.g., liquid carrier, polyhydroxy aromatic compound, polyvinyl alcohol, optional pH adjustor, and/or any optional additive) in a (e.g., cerium oxide) slurry, (ii) providing one or more components in an additive solution (e.g., liquid carrier, ionic polymer, polyhydroxy aromatic compound, polyvinyl alcohol, optional pH adjustor, and/or any optional additive), (iii) combining the (e.g., cerium oxide) slurry and the additive solution to form a mixture, (iv) optionally adding suitable amounts of any other optional additives to the mixture, and (v) adjusting the pH of the mixture as appropriate.

The polishing composition can be supplied as a one-package system comprising a abrasive (e.g., wet process ceria ceria), ionic polymer, polyhydroxy aromatic compound, polyvinyl alcohol, optional pH adjustor, and/or any optional additive, and water. Alternatively, the polishing composition of the invention is supplied as a two-package system comprising a (e.g., cerium oxide) slurry and an additive solution, wherein the (e.g., cerium oxide) slurry consists essentially of, or consists of an abrasive (e.g., cerium oxide) and/or any optional additive, and water, and wherein the additive solution consists essentially of, or consists of, ionic polymer, polyhydroxy aromatic compound, polyvinyl alcohol, optional pH adjustor, and/or any optional additive. The two-package system allows for the adjustment of substrate global flattening characteristics and polishing speed by changing the blending ratio of the two packages, i.e., the (e.g., cerium oxide) slurry and the additive solution.

Various methods can be employed to utilize such a two-package polishing system. For example, the (e.g., cerium oxide) slurry and additive solution can be delivered to the polishing table by different pipes that are joined and connected at the outlet of supply piping. The (e.g., cerium oxide) slurry and additive solution can be mixed shortly or immediately before polishing, or can be supplied simultaneously on the polishing table. Furthermore, when mixing the two packages, deionized water can be added, as desired, to adjust the polishing composition and resulting substrate polishing characteristics.

Similarly, a three-, four-, or more package system can be utilized in connection with the invention, wherein each of multiple containers contains different components of the inventive chemical-mechanical polishing composition, one or more optional components, and/or one or more of the same components in different concentrations.

In order to mix components contained in two or more storage devices to produce the polishing composition at or near the point-of-use, the storage devices typically are provided with one or more flow lines leading from each storage device to the point-of-use of the polishing composition (e.g., the platen, the polishing pad, or the substrate surface). As utilized herein, the term "point-of-use" refers to the point at which the polishing composition is applied to the substrate surface (e.g., the polishing pad or the substrate surface itself). The term "flow line" refers to a path of flow from an individual storage container to the point-of-use of the component stored therein. The flow lines can each lead directly to the point-of-use, or two or more of the flow lines can be combined at any point into a single flow line that leads to the point-of-use. Furthermore, any of the flow lines (e.g., the individual flow lines or a combined flow line) can first lead to one or more other devices (e.g., a pumping device, measuring device, mixing device, etc.) prior to reaching the point-of-use of the component(s).

The components of the polishing composition can be delivered to the point-of-use independently (e.g., the components are delivered to the substrate surface whereupon the components are mixed during the polishing process), or one or more of the components can be combined before delivery to the point-of-use, e.g., shortly or immediately before delivery to the point-of-use. Components are combined "immediately before delivery to the point-of-use" if the components are combined about 5 minutes or less prior to being added in mixed form onto the platen, for example, about 4 minutes or less, about 3 minutes or less, about 2 minutes or less, about 1 minute or less, about 45 s or less, about 30 s or less, about 10 s or less prior to being added in mixed form onto the platen, or simultaneously to the delivery of the components at the point-of-use (e.g., the components are combined at a dispenser). Components also are combined "immediately before delivery to the point-of-use" if the components are combined within 5 m of the point-of-use, such as within 1 m of the point-of-use or even within 10 cm of the point-of-use (e.g., within 1 cm of the point-of-use).

When two or more of the components of the polishing composition are combined prior to reaching the point-of-use, the components can be combined in the flow line and delivered to the point-of-use without the use of a mixing device. Alternatively, one or more of the flow lines can lead into a mixing device to facilitate the combination of two or more of the components. Any suitable mixing device can be used. For example, the mixing device can be a nozzle or jet (e.g., a high pressure nozzle or jet) through which two or more of the components flow. Alternatively, the mixing device can be a container-type mixing device comprising one or more inlets by which two or more components of the polishing slurry are introduced to the mixer, and at least one outlet through which the mixed components exit the mixer to be delivered to the point-of-use, either directly or via other elements of the apparatus (e.g., via one or more flow lines). Furthermore, the mixing device can comprise more than one chamber, each chamber having at least one inlet and at least one outlet, wherein two or more components are combined in each chamber. If a container-type mixing device is used, the mixing device preferably comprises a mixing mechanism to further facilitate the combination of the components. Mixing mechanisms are generally known in the art and include stirrers, blenders, agitators, paddled baffles, gas sparger systems, vibrators, etc.

The polishing composition also can be provided as a concentrate which is intended to be diluted with an appropriate amount of water prior to use. In such an embodiment, the polishing composition concentrate comprises the components of the polishing composition in amounts such that, upon dilution of the concentrate with an appropriate amount of water, each component of the polishing composition will be present in the polishing composition in an amount within the appropriate range recited above for each component. For example, the ceria abrasive, ionic polymer, polyhydroxy aromatic compound, polyvinyl alcohol, optional pH adjustor, and/or any optional additive can each be present in the concentrate in an amount that is about 2 times (e.g., about 3 times, about 4 times, or about 5 times) greater than the concentration recited above for each component so that, when the concentrate is diluted with an equal volume of water (e.g., 2 equal volumes of water, 3 equal volumes of water, or 4 equal volumes of water, respectively), each component will be present in the polishing composition in an amount within the ranges set forth above for each component. Furthermore, as will be understood by those of ordinary skill in the art, the concentrate can contain an appropriate fraction of the water present in the final polishing composition in order to ensure that the abrasive (e.g., wet process ceria), ionic polymer, polyhydroxy aromatic compound, polyvinyl alcohol, optional pH adjustor, and/or any optional additive are at least partially or fully dissolved in the concentrate. The chemical-mechanical polishing composition can be used to polish any suitable substrate and is especially useful for polishing substrates comprising at least one layer (typically a surface layer) comprised of a low dielectric material. Suitable substrates include wafers used in the semiconductor industry. The wafers typically comprise or consist of, for example, a metal, metal oxide, metal nitride, metal composite, metal alloy, a low dielectric material, or combinations thereof. The method of the invention is particularly useful for polishing substrates comprising silicon oxide, silicon nitride, and/or polysilicon, e.g., any one, two, or especially all three of the aforementioned materials.

In certain embodiments, the substrate comprises polysilicon in combination with silicon oxide and/or silicon nitride. The polysilicon can be any suitable polysilicon, many of which are known in the art. The polysilicon can have any suitable phase, and can be amorphous, crystalline, or a combination thereof. The silicon oxide similarly can be any suitable silicon oxide, many of which are known in the art. Suitable types of silicon oxide include but are not limited to borophosphosilicate glass (BPSG), PETEOS, thermal oxide, undoped silicate glass, and HDP oxide.

The chemical-mechanical polishing composition of the invention desirably exhibits a high removal rate when polishing a substrate comprising silicon oxide according to a method of the invention. For example, when polishing silicon wafers comprising high density plasma (HDP) oxides and/or plasma-enhanced tetraethyl ortho silicate (PETEOS) and/or tetraethyl orthosilicate (TEOS) in accordance with an embodiment of the invention, the polishing composition desirably exhibits a silicon oxide removal rate of about 500 Å/min or higher, 700 Å/min or higher, about 1,000 Å/min or higher, about 1,250 Å/min or higher, about 1,500 Å/min or higher, about 1,750 Å/min or higher, about 2,000 Å/min or higher, about 2,500 Å/min or higher, about 3,000 Å/min or higher, about 3,500 Å/min or higher. In an embodiment, removal rate for silicon oxide can be about 4,000 Å/min or higher, about 4,500 Å/min or higher, or about 5,000 Å/min or higher.

The chemical-mechanical polishing composition of the invention desirably exhibits a low removal rate when polishing a substrate comprising silicon nitride according to a method of the invention. For example, when polishing silicon wafers comprising silicon nitride in accordance with an embodiment of the invention, the polishing composition desirably exhibits a removal rate of the silicon nitride of about 250 Å/min or lower, for example, about 200 Å/min or lower, about 150 Å/min or lower, about 100 Å/min or lower, about 75 Å/min or lower, about 50 Å/min or lower, or even about 25 Å/min or lower.

The chemical-mechanical polishing composition of the invention desirably exhibits a low removal rate when polishing a substrate comprising polysilicon according to a method of the invention. For example, when polishing silicon wafers comprising polysilicon in accordance with an embodiment of the invention, the polishing composition desirably exhibits a removal rate of polysilicon of about 1,000 Å/min or lower, about 750 Å/min or lower, about 500 Å/min or lower, about 250 Å/min or lower, about 100 Å/min or lower, about 50 Å/min or lower, about 25 Å/min or lower, about 10 Å/min or lower, or even about 5 Å/min or lower.

The chemical-mechanical polishing composition of the invention desirably exhibits reduced dishing when used to polish substrates comprising silicon oxide and silicon nitride, particularly when used in an STI process. In the STI process, polishing is typically continued after the silicon nitride layer is exposed to ensure complete removal of silicon oxide from the silicon nitride surface. During this overpolishing period, silicon oxide remaining in the trench can continue to be removed, such that the surface of the silicon oxide remaining in the trench is lower than the surface of the silicon nitride, which results in the phenomenon referred to as dishing. Without wishing to be bound by any particular theory, it is believed that the polyhydroxy aromatic compound selectively binds to the surface of the silicon oxide present in the trench, thereby inhibiting further removal of the silicon oxide.

A substrate, especially silicon comprising silicon oxide and/or silicon nitride and/or polysilicon, polished with the inventive polishing composition desirably has a dishing that is about 500 Å or less, e.g., about 500 Å or less, about 450 Å or less, about 400 Å or less, about 350 Å or less, about 300 Å or less, about 250 Å or less, about 200 Å or less, about 150 Å or less, about 100 Å or less, or about 50 Å or less.

The polishing composition of the invention desirably exhibits low particle defects when polishing a substrate, as determined by suitable techniques. In a preferred embodiment, the chemical-mechanical polishing composition of the invention comprises a wet-process ceria which contributes to the low defectivity. Particle defects on a substrate polished with the inventive polishing composition can be determined by any suitable technique. For example, laser light scattering techniques, such as dark field normal beam composite (DCN) and dark field oblique beam composite (DCO), can be used to determine particle defects on polished substrates. Suitable instrumentation for evaluating particle defectivity is available from, for example, KLA-Tencor (e.g., SURFSCAN^{™} SP1 instruments operating at a 120 nm threshold or at 160 nm threshold).

A substrate, especially silicon comprising silicon oxide and/or silicon nitride and/or polysilicon, polished with the inventive polishing composition desirably has a DCN value of about 20,000 counts or less, e.g., about 17,500 counts or less, about 15,000 counts or less, about 12,500 counts or less, about 3,500 counts or less, about 3,000 counts or less, about 2,500 counts or less, about 2,000 counts or less, about 1,500 counts or less, or about 1,000 counts or less. Preferably, a substrate polished in accordance with an embodiment of the invention has a DCN value of about 750 counts or less, about 500 counts, about 250 counts, about 125 counts, or even about 100 counts or less. Alternatively, or in addition, a substrate polished with the chemical-mechanical polishing composition of the invention desirably exhibits low scratches as determined by suitable techniques. For example, silicon wafers polished in accordance with an embodiment of the invention desirably have about 250 scratches or less, or about 125 scratches or less, as determined by any suitable method known in the art.

The chemical-mechanical polishing composition of the invention can be tailored to provide effective polishing at the desired polishing ranges selective to specific thin layer materials, while at the same time minimizing surface imperfections, defects, corrosion, erosion, and the removal of stop layers. The selectivity can be controlled, to some extent, by altering the relative concentrations of the components of the polishing composition. When desirable, the chemical-mechanical polishing composition of the invention can be used to polish a substrate with a silicon dioxide to silicon nitride polishing selectivity of about 5:1 or higher (e.g., about 10:1 or higher, about 15:1 or higher, about 25:1 or higher, about 50:1 or higher, about 100:1 or higher, or about 150:1 or even higher). When desirable, the chemical-mechanical polishing composition of the invention can be used to polish a substrate with a silicon dioxide to polysilicon polishing selectivity of about 5:1 or higher (e.g., about 10:1 or higher, about 15:1 or higher, about 25:1 or higher, about 50:1 or higher, about 100:1 or higher, or about 150:1 or even higher). Also, the chemical-mechanical polishing composition of the invention can be used to polish a substrate with a silicon nitride to polysilicon polishing selectivity of about 2:1 or higher (e.g., about 4:1 or higher, or about 6:1 or higher). Certain formulations can exhibit even higher silicon dioxide to polysilicon selectivities, such as about 20:1 or higher, or even about 30:1 or higher. In a preferred embodiment, the chemical-mechanical polishing composition of the invention simultaneously provides selective polishing of silicon dioxide relative to silicon nitride and selective polishing of silicon dioxide relative to polysilicon.

The chemical-mechanical polishing composition and method of the invention are particularly suited for use in conjunction with a chemical-mechanical polishing apparatus. Typically, the apparatus comprises a platen, which, when in use, is in motion and has a velocity that results from orbital, linear, or circular motion, a polishing pad in contact with the platen and moving with the platen when in motion, and a carrier that holds a substrate to be polished by contacting and moving the substrate relative to the surface of the polishing pad. The polishing of the substrate takes place by the substrate being placed in contact with the polishing pad and the polishing composition of the invention, and then the polishing pad moving relative to the substrate, so as to abrade at least a portion of the substrate to polish the substrate.

A substrate can be polished with the chemical-mechanical polishing composition using any suitable polishing pad (e.g., polishing surface). Suitable polishing pads include, for example, woven and non-woven polishing pads. Moreover, suitable polishing pads can comprise any suitable polymer of varying density, hardness, thickness, compressibility, ability to rebound upon compression, and compression modulus. Suitable polymers include, for example, polyvinylchloride, polyvinylfluoride, nylon, fluorocarbon, polycarbonate, polyester, polyacrylate, polyether, polyethylene, polyamide, polyurethane, polystyrene, polypropylene, coformed products thereof, and mixtures thereof. Soft polyurethane polishing pads are particularly useful in conjunction with the inventive polishing method. Typical pads include but are not limited to SURFIN^{™} 000, SURFIN^{™} SSW1, SPM3100 (commercially available from, for example, Eminess Technologies), POLITEX^{™}, and Fujibo POLYPAS^{™} 27. A particularly preferred polishing pad is the EPIC^{™} D100 pad commercially available from Cabot Microelectronics. Another preferred polishing pad is the IC1010 pad available from Dow, Inc.

Desirably, the chemical-mechanical polishing apparatus further comprises an *in situ* polishing endpoint detection system, many of which are known in the art. Techniques for inspecting and monitoring the polishing process by analyzing light or other radiation reflected from a surface of the substrate being polished are known in the art. Such methods are described, for example, in U.S. Patent 5,196,353, U.S. Patent 5,433,651, U.S. Patent 5,609,511, U.S. Patent 5,643,046, U.S. Patent 5,658,183, U.S. Patent 5,730,642, U.S. Patent 5,838,447, U.S. Patent 5,872,633, U.S. Patent 5,893,796, U.S. Patent 5,949,927, and U.S. Patent 5,964,643. Desirably, the inspection or monitoring of the progress of the polishing process with respect to a substrate being polished enables the determination of the polishing end-point, i.e., the determination of when to terminate the polishing process with respect to a particular substrate.

The following examples further illustrate the invention but, of course, should not be construed as in any way limiting its scope.

### EXAMPLE 1

This example demonstrates the effect on removal rate of carbon-doped silicon oxide film (blanket wafers) polished with Polishing Compositions 1A-1G. The polishing compositions contained ceria in the form of wet processed ceria, or silica in the form of colloids, in the solids amounts indicated in Table 1A. The polishing compositions containing silica in the form of colloids are not part of the claimed invention. The ceria and silica particles had an average particle size of 150 nm or less. Additionally, the pH values of the polishing compositions are listed in Table 1A.

In particular, the blanket wafers of carbon-doped silicon oxide film were polished with Polishing Compositions 1A-1G on a REFLEXION^{™} CMP apparatus (Applied Materials, Inc., Santa Clara, California). The polishing parameters of the REFLEXION^{™} process are set forth in Table 1B below. The carbon-doped silicon oxide film was a low dielectric (low-k) film and contained 20% by weight of carbon, 35% by weight of silicon, and 45% by weight of oxygen.

**Table 1A: Polishing Composition Summary**

| Polishing Composition | Abrasive | Abrasive Solid Content (wt.%) | pH | Removal Rate of Carbon-Doped Film (Å/min) |
|---|---|---|---|---|
| 1A | Ceria | 0.40% | 4.0 | 306 |
| 1B | Ceria | 0.40% | 5.0 | 1888 |
| 1C | Ceria | 0.40% | 5.5 | 2843 |
| 1D | Silica (comparative) | 2.0% | 4.0 | <20 |
| 1E | Ceria | 0.28% | 5.0 | 1012 |
| IF | Ceria | 0.40% | 5.0 | 1955 |
| 1G | Ceria | 0.57% | 5.0 | 2514 |

**Table 1B: REFLEXION^{™} Process Parameters**

| Parameter | Value |
|---|---|
| Retaining Ring Pressure | 52.4 kPa (7.6 psi) |
| Zone 1 | 6.8 kPa |
| Zone 2 | 3.7 kPa |
| Zone 3 | 3.0 kPa |
| Head Speed | 125 rpm |
| Platen Speed | 126 rpm |
| Flow Rate | 250 ml/min |
| Conditioner | Model S8031C7 (Saesol Diamond Ind., Co., Ltd., Korea) |
| Conditioner Downforce | 1.81 kg (4 lb) |

| Conditioning | 100% in situ |
|---|---|
| Polishing Pad | Dow IC1010^{™} polishing pad |

These results demonstrate that ceria particles polished carbon-doped silicon oxide film with high removal rate. This result was surprising in view of the content of carbon in the film, which was 20% by weight. Achieving such a high removal rate for carbon-doped silicon oxide films had previously been difficult because even a small carbon content (here 20%) in silicon oxide materials impart hydrophobicity to the surface. As seen in this example, due to this hydrophobicity, compositions 1A and 1D were not able to polish carbon-doped films, although these compositions can effectively polish undoped silicon oxide with high removal rates (e.g., >3000 Å /min).

Polishing compositions 1B, 1C, IE, IF, and 1G all showed high removal rates at pH 5.5 and with increased solids content of ceria. While not wishing to be bound by any particular theory, it is believed that the higher negative zeta potential originated by shifting the pH to 5.5 increases the electrostatic attraction between positively charged ceria particles and the substrate surface to thereby increase the removal rate. Increasing the solids level from 0.28 wt.% to 0.4 wt.% increased mechanical action and further improved the removal rate. Additionally, the results show that colloidal ceria particles can be used to polish a hydrophobic surface without using a wetting agent.

### EXAMPLE 2

This example demonstrates a polishing composition that can polish carbon-doped silicon oxide film from a shallow trench isolation (STI) pattern wafer surface with "stop on nitride" capability. A polishing composition was prepared containing ceria particles in an amount of 0.2 wt.% and having an average particle size of 150 nm or less. The polishing composition also contained polyethylene glycol diacid in an amount of 0.03 wt.% , poly vinyl alcohol in an mount of 0.06% and trihydroxybenzene in an amount of 0.025 wt.%. The polishing composition had a pH of 3.5. Ammonium hydroxide was added to reach the desired pH. The remainder of the composition was water.

In particular, the polishing composition was used to polish the STI wafer coated with carbon-doped silicon oxide film. The wafer contained a silicon nitride layer formed on a silicon substrate, containing shallow trenches formed therein, and was obtained from Silyb Wafer Services, Inc., Gig Harbor, Washington. A dielectric layer in the form of the carbon-doped silicon oxide film was deposited to fill the trenches. The carbon-doped silicon oxide film was a low-k film and was obtained from Lams Research, Fremont, CA, and contained 20% by weight of carbon, 35% by weight of silicon, and 45% by weight of oxygen. The polishing was performed using the apparatus and procedures described in Example 1.

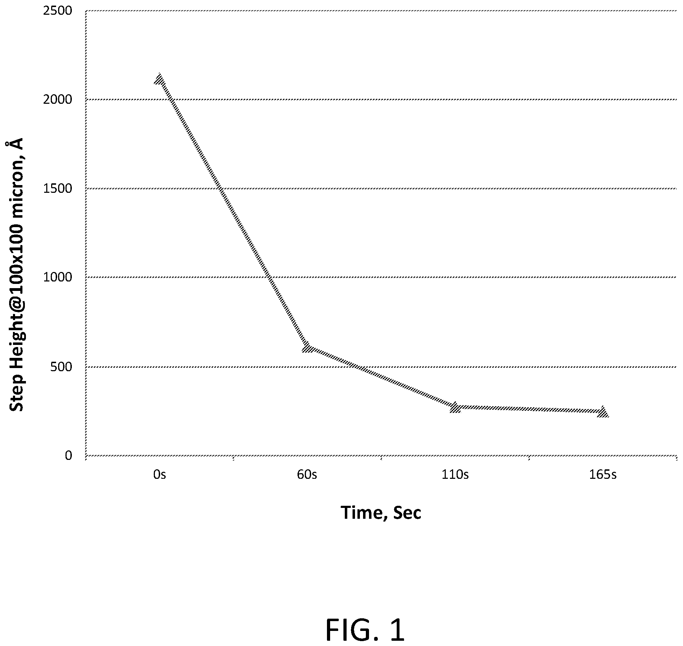

The polishing and planarization performance of the carbon-doped silicon oxide film deposited STI wafer is shown in FIG. 1, which is a plot illustrating the step height measured in Angstroms (Å) as a function of total polishing time in seconds. The step height is a measurement of planarization efficiency. It was measured by a Vx310 atomic profilometer, commercially available from Veeco Instruments, Inc., Plainview, New York. "100 X 100 micron" indicates the size of the feature present on the pattern wafer from which the carbon-doped film is being polished. FIG. 1 illustrates that the polishing composition of this example achieved effective planarization, with a high initial step height over 2000 Å and a final step height of approximately 270 Å.

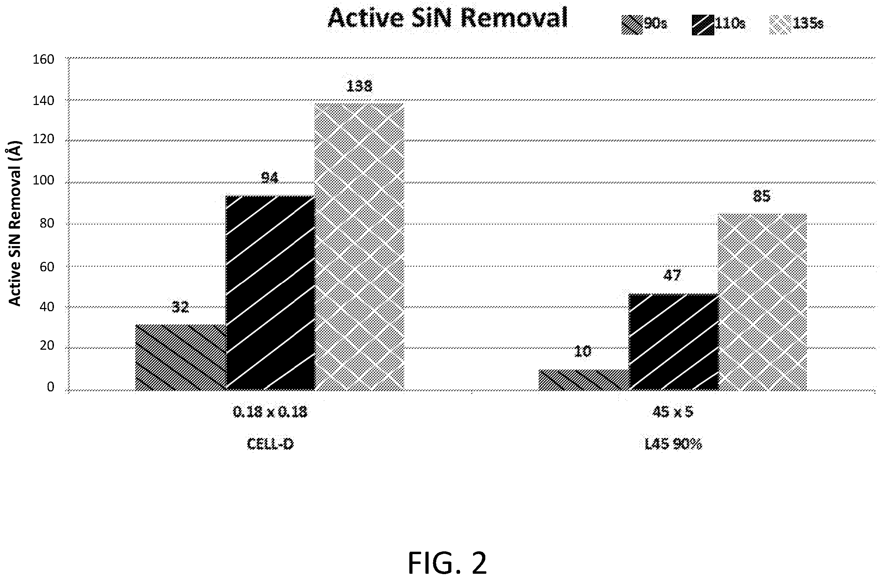

A polishing test was performed to determine the selectivity of the polishing composition for silicon nitride removal. The results are shown in FIG. 2, which is a graph of silicon nitride (SiN) removal (Y-axis) versus total polishing time in seconds (X-axis) for the polishing composition. As seen in FIG. 2, three STI pattern wafers filled with carbon-doped silicon oxide films were polished for three different time periods (90 seconds, 110 seconds, 135 seconds), such that two sets of bar graphs are provided. "Cell-D" and "L45 90%" refer to two different features present on the STI pattern surface with a size of 0.18 x 0.18 µm and 45x5 µm, respectively, obtained from Silyb Wafer Services, Inc. As seen in FIG. 2, the polishing did not remove significant amounts of silicon nitride from both features, thereby indicating good selectivity.

### EXAMPLE 3

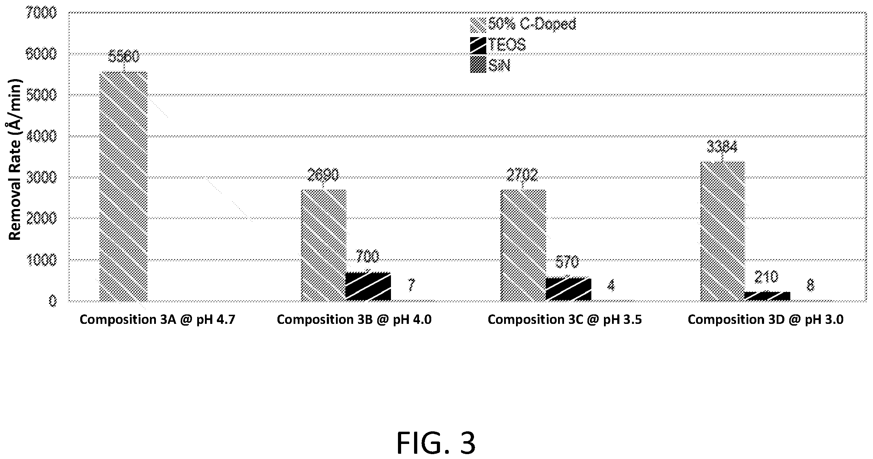

This example demonstrates the effect on removal rate of carbon-doped silicon oxide film (blanket wafers) polished with Polishing Compositions 3A-3D. The polishing compositions contained ceria in the form of wet processed ceria, in a solids amount of 0.4 wt.%. The ceria particles had an average particle size of 150 nm or less. The polishing composition also contained polyethylene glycol diacid in an amount of 0.03 wt.% and poly vinyl alcohol in an mount of 0.06%. Each of the polishing compositions had a pH between 3 and 4.7 as shown in FIG. 3. The difference in pH was achieved by adding ammonium hydroxide. The remainder of each composition was water.

In particular, the blanket wafers of carbon-doped silicon oxide film were polished with Polishing Compositions 3A-3D. The carbon-doped silicon oxide film was a low-k film and contained 50% by weight of carbon, 25% by weight of silicon, and 22% by weight of oxygen. In addition, wafers of tetraethyl orthosilicate (TEOS) and silicon nitride (SiN) were polished for selectivity. The polishing was performed using the Logitech table top polisher with Dow IC1010^{™} polishing pad. The polishing parameters were as follows: 10.34 kPa (1.5 psi) down force, 60 rpm platen speed, 57 rpm head speed, and 100 mL/min polishing composition flow.

The removal rate performance is shown in FIG. 3, which is a bar graph illustrating the removal rate measured in Angstroms per minute (Å/min) for each of the four compositions 3A-3D and for each of the three wafers (the 50% carbon-doped silicon oxide, the TEOS, and the SiN). For composition 3A, TEOS and SiN were not tested.

These results demonstrate a high removal rate for carbon-doped silicon oxide film containing 50% carbon at high pH. This was because of higher negative zeta potential originated by shifting the pH to 5.5, which increased the electrostatic attraction between positively charged ceria particles and the substrate surface. The low removal rates of TEOS, especially at low pH (composition 3D) and SiN (all composition) indicate the polishing composition formulation can be used to polish selectively carbon-doped films from a surface of silicon nitride and silicon oxide films.

## Claims

1. A method of chemically-mechanically polishing a substrate, the method comprising:
(a) contacting a substrate containing a low-k dielectric composition, wherein the low-k dielectric composition has a dielectric constant between 2 and 3 and the low-k dielectric composition includes less than about 50% by weight of carbon, with a polishing pad and a chemical-mechanical polishing composition comprising water and abrasive particles having a positive surface charge and a zeta potential of at least about +10 mV, wherein the abrasive particles include wet process ceria and wherein the polishing composition has a pH of from about 3 to about 6;
(b) moving the polishing pad and the chemical-mechanical polishing composition relative to the substrate; and
(c) abrading at least a portion of the substrate to polish the substrate.

2. The method of claim 1, wherein the low-k dielectric composition includes less than about 30% by weight of carbon.

3. The method of claim 1, wherein the low-k dielectric composition is carbon-doped silicon oxide.

4. The method of claim 3, wherein a) the carbon-doped silicon oxide includes at least 35% by weight silicon; or
b) the carbon-doped silicon oxide includes at least 45% by weight oxygen.

5. The method of claim 1, wherein the abrasive particles are present in an amount of about 0.05 wt.% to about 2 wt.% of the polishing composition.

6. The method of claim 1, wherein the pH of the composition is from about 3 to about 5.6,
wherein optionally the pH of the composition is from about 5 to about 5.6.

7. The method of claim 1, wherein the polishing composition further comprises an ionic polymer of formula (I): 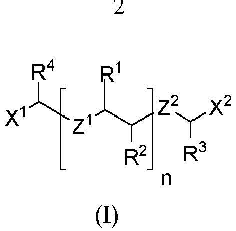
wherein X¹ and X² are independently selected from hydrogen, -OH, and - COOH, and wherein at least one of X¹ and X² is -COOH,
Z¹ and Z² are independently O or S,
R¹, R², R³, and R⁴ are independently selected from hydrogen, C₁-C₆ alkyl, and C₇-C₁₀ aryl, and
n is an integer of about 3 to about 500.

8. The method of claim 7, wherein any one or more of the following applies,
a) X¹ and X² are both -COOH;
b) Z¹ and Z² are both O, and R¹, R², R³, and R⁴ are hydrogen;
c) the ionic polymer has a molecular weight of about 500 g/mol to about 10,000 g/mol, and wherein n is an integer with a value of 8 or greater;
d) the ionic polymer is a polyethylene glycol diacid; and
e) the ionic polymer is present in an amount of about 0.01 wt.% to about 0.5 wt.% of the polishing composition.

9. The method of claim 1, wherein the polishing composition further comprises a polyhydroxy aromatic compound, wherein optionally any one or more of the following applies,
a) the polyhydroxy aromatic compound is selected from 1,3-dihydroxybenzene and 1,3,5-trihydroxybenzene;
b) the polyhydroxy aromatic compound is 1,3,5-trihydroxybenzene; and
c) the polyhydroxy aromatic is present in an amount of about 0 wt.% to about 0.5 wt.% of the polishing composition.

10. The method of claim 1, wherein the polishing composition further comprises polyvinyl alcohol,wherein optionally any one or more of the following applies,
a) the polyvinyl alcohol has a molecular weight of about 20,000 g/mol to about 200,000 g/mol;
b) the polyvinyl alcohol is a branched polyvinyl alcohol; and
c) the polyvinyl alcohol is present in an amount of about 0.05 wt.% to about 0.5 wt.% of the polishing composition.

11. The method of claim 1, wherein the substrate further contains silicon nitride, and wherein abrading at least a portion of the surface of the substrate removes less than about 20 Å/min of silicon nitride from the surface of the substrate.

## Patentansprüche

1. Verfahren zum chemisch-mechanischen Polieren eines Substrats, wobei das Verfahren umfasst:
(a) Inkontaktbringen eines Substrats, das eine dielektrische Zusammensetzung mit niedrigem k-Wert umfasst, wobei die dielektrische Zusammensetzung mit niedrigem k-Wert eine Dielektrizitätskonstante zwischen 2 und 3 aufweist und die dielektrische Zusammensetzung mit niedrigem k-Wert weniger als etwa 50 Gew.-% Kohlenstoff enthält, mit einem Polierkissen und einer chemisch-mechanischen Polierzusammensetzung, die Wasser und abrasive Partikel mit einer positiven Oberflächenladung und einem Zeta-Potential von wenigstens etwa +10 mV umfasst, wobei die abrasiven Partikel Nassverarbeitungs-Cerdioxid umfassen und wobei die Polierzusammensetzung einen pH-Wert von etwa 3 bis etwa 6 aufweist;
(b) Bewegen des Polierkissens und der chemisch-mechanischen Polierzusammensetzung relativ zu dem Substrat; und
(c) Abradieren wenigstens eines Teils des Substrats, um das Substrat zu polieren.

2. Verfahren gemäß Anspruch 1, wobei die dielektrische Zusammensetzung mit niedrigem k-Wert weniger als etwa 30 Gew.-% Kohlenstoff enthält.

3. Verfahren gemäß Anspruch 1, wobei die dielektrische Zusammensetzung mit niedrigem k-Wert kohlenstoffdotiertes Siliciumoxid ist.

4. Verfahren gemäß Anspruch 3, wobei
a) das kohlenstoffdotierte Siliciumoxid wenigstens 35 Gew.-% Silicium enthält; oder
b) das kohlenstoffdotierte Siliciumoxid wenigstens 45 Gew.-% Sauerstoff enthält.

5. Verfahren gemäß Anspruch 1, wobei die abrasiven Partikel in einer Menge von etwa 0,05 Gew.-% bis etwa 2 Gew.-% der Polierzusammensetzung vorhanden sind.

6. Verfahren gemäß Anspruch 1, wobei der pH-Wert der Zusammensetzung von etwa 3 bis etwa 5,6 beträgt,
wobei der pH-Wert der Zusammensetzung gegebenenfalls von etwa 5 bis etwa 5,6 beträgt.

7. Verfahren gemäß Anspruch 1, wobei die Polierzusammensetzung ferner ein ionisches Polymer der Formel (I) umfasst: 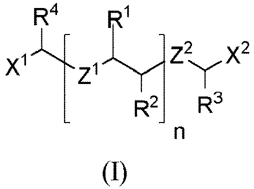
wobei X¹ und X² unabhängig ausgewählt sind aus Wasserstoff, -OH und -COOH und wobei wenigstens eines von X¹ und X² -COOH ist,
Z¹ und Z² unabhängig O oder S sind,
R¹, R², R³ und R⁴ unabhängig ausgewählt sind aus Wasserstoff, C₁-C₆-Alkyl und C₇-C₁₀-Aryl und
n eine ganze Zahl von etwa 3 bis etwa 500 ist.

8. Verfahren gemäß Anspruch 7, wobei eines oder mehrere von folgendem zutrifft:
a) X¹ und X² sind beide -COOH;
b) Z¹ und Z² sind beide O und R¹, R², R³ und R⁴ sind Wasserstoff;
c) das ionische Polymer weist ein Molekulargewicht von etwa 500 g/mol bis etwa 10.000 g/mol auf, und wobei n eine ganze Zahl mit einem Wert von 8 oder größer ist;
d) das ionische Polymer ist eine Polyethylenglycoldisäure; und
e) das ionische Polymer ist in einer Menge von etwa 0,01 Gew.-% bis etwa 0,5 Gew.-% der Polierzusammensetzung vorhanden.

9. Verfahren gemäß Anspruch 1, wobei die Polierzusammensetzung ferner eine aromatische Polyhydroxyverbindung umfasst, wobei gegebenenfalls eines oder mehrere von folgendem zutrifft:
a) die aromatische Polyhydroxyverbindung ist ausgewählt aus 1,3-Dihydroxybenzol und 1,3,5-Trihydroxybenzol;
b) die aromatische Polyhydroxyverbindung ist 1,3,5-Trihydroxybenzol; und
c) das aromatische Polyhydroxy ist in einer Menge von etwa 0 Gew.-% bis etwa 0,5 Gew.-% der Polierzusammensetzung vorhanden.

10. Verfahren gemäß Anspruch 1, wobei die Polierzusammensetzung ferner Polyvinylalkohol umfasst, wobei gegebenenfalls eines oder mehrere von folgendem zutrifft:
a) der Polyvinylalkohol weist ein Molekulargewicht von etwa 20.000 g/mol bis etwa 200.000 g/mol auf;
b) der Polyvinylalkohol ist ein verzweigter Polyvinylalkohol; und
c) der Polyvinylalkohol ist in einer Menge von etwa 0,05 Gew.-% bis etwa 0,5 Gew.-% der Polierzusammensetzung vorhanden.

11. Verfahren gemäß Anspruch 1, wobei das Substrat ferner Siliciumnitrid enthält und wobei Abradieren wenigstens eines Teils der Oberfläche des Substrats weniger als etwa 20 Å/min Siliciumnitrid von der Oberfläche des Substrats entfernt.

## Revendications

1. Procédé de polissage mécano-chimique d'un substrat, le procédé comprenant :
(a) la mise en contact d'un substrat contenant une composition diélectrique à bas k, la composition diélectrique à bas k possédant une constante diélectrique comprise entre 2 et 3 et la composition diélectrique à bas k comprenant moins d'environ 50 % en poids de carbone, avec un tampon de polissage et une composition de polissage mécano-chimique comprenant de l'eau et des particules abrasives possédant une charge de surface positive et un potentiel zêta d'au moins environ + 10 mV, les particules abrasives comprenant de l'oxyde de cérium obtenu par un processus par voie humide et la composition de polissage possédant un pH allant d'environ 3 à environ 6 ;
(b) le déplacement du tampon de polissage et de la composition de polissage mécano-chimique par rapport au substrat ; et
(c) l'abrasion d'au moins une partie du substrat pour polir le substrat.

2. Procédé selon la revendication 1, la composition diélectrique à bas k comprenant moins d'environ 30 % en poids de carbone.

3. Procédé selon la revendication 1, la composition diélectrique à bas k étant de l'oxyde de silicium dopé au carbone.

4. Procédé selon la revendication 3, a) l'oxyde de silicium dopé au carbone comprenant au moins 35 % en poids de silicium ; ou
b) l'oxyde de silicium dopé au carbone comprenant au moins 45 % en poids d'oxygène.

5. Procédé selon la revendication 1, les particules abrasives étant présentes en une quantité d'environ 0,05 % en poids à environ 2 % en poids de la composition de polissage.

6. Procédé selon la revendication 1, le pH de la composition étant d'environ 3 à environ 5,6, éventuellement le pH de la composition étant d'environ 5 à environ 5,6.

7. Procédé selon la revendication 1, la composition de polissage comprenant en outre un polymère ionique de formule (I) : 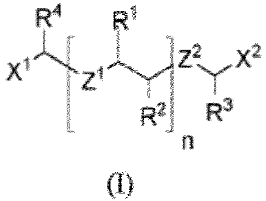
X¹ et X² étant indépendamment choisis parmi hydrogène, -OH, et -COOH, et au moins l'un parmi X¹ et X² étant -COOH,
Z¹ et Z² étant indépendamment O ou S,
R¹, R², R³ et R⁴ étant indépendamment choisis parmi hydrogène, C₁₋₆ alkyle, et C₇₋₁₀ aryle, et
n étant un entier d'environ 3 à environ 500.

8. Procédé selon la revendication 7, un quelconque ou plusieurs des énoncés suivants s'appliquant,
a) X¹ et X² sont tous deux -COOH ;
b) Z¹ et Z² sont tous deux O, et R¹, R², R³ et R⁴ sont hydrogène ;
c) le polymère ionique possède un poids moléculaire d'environ 500 g/mole à environ 10 000 g/mole, et n étant un entier doté d'une valeur de 8 ou plus ;
d) le polymère ionique est un diacide de polyéthylène glycol ; et
e) le polymère ionique est présent en une quantité d'environ 0,01 % en poids à environ 0,5 % en poids de la composition de polissage.

9. Procédé selon la revendication 1, la composition de polissage comprenant en outre un composé polyhydroxy aromatique, éventuellement un quelconque ou plusieurs des énoncés suivants s'appliquant,
a) le composé polyhydroxy aromatique est choisi parmi le 1,3-dihydroxybenzène et le 1,3,5-trihydroxybenzène ;
b) le composé polyhydroxy aromatique est le 1,3,5-trihydroxybenzène ; et
c) l'aromatique polyhydroxy est présent en une quantité d'environ 0 % en poids à environ 0,5 % en poids de la composition de polissage.

10. Procédé selon la revendication 1, la composition de polissage comprenant en outre un poly(alcool vinylique), éventuellement un ou plusieurs des énoncés suivants s'appliquant,
a) le poly(alcool vinylique) possède un poids moléculaire d'environ 20 000 g/mole à environ 200 000 g/mole ;
b) le poly(alcool vinylique) est un poly(alcool vinylique) ramifié ; et
c) le poly(alcool vinylique) est présent en une quantité d'environ 0,05 % en poids à environ 0,5 % en poids de la composition de polissage.

11. Procédé selon la revendication 1, le substrat contenant en outre du nitrure de silicium, et l'abrasion d'au moins une partie de la surface du substrat éliminant moins d'environ 20 Å/min de nitrure de silicium de la surface du substrat.
